# EUROPEAN PATENT SPECIFICATION

(11) **EP 3 808 100 B1**
(45) Date of publication and mention of the grant of the patent: **19.02.2025**
(21) Application number: 18752731.2
(22) Date of filing: 06.08.2018
(51) Int. Cl.: H04R 11/02, H01F 7/02, H05K 1/16, H01F 7/06, H05K 1/02

(54) **PRINTED WIRING BOARD FOR AN ELECTRONIC DEVICE AND ELECTRONIC DEVICE COMPRISING SAID PRINTED WIRING BOARD**
LEITERPLATTE FÜR EINE ELEKTRONISCHE VORRICHTUNG UND ELEKTRONISCHE VORRICHTUNG MIT DIESER LEITERPLATTE
CARTE DE CIRCUIT IMPRIMÉ POUR UN DISPOSITIF ÉLECTRONIQUE ET DISPOSITIF ÉLECTRONIQUE COMPRENANT LADITE CARTE DE CIRCUIT IMPRIMÉ

(43) Date of publication of application: 21.04.2021
(73) Proprietor: HUAWEI TECHNOLOGIES CO., LTD., Shenzhen, Guangdong 518129 (CN)
(72) Inventor: MÄKI, Jouni, Tapio, 16440 Kista (SE); MAENPAA, Ossi, Shenzhen, Guangdong 518129 (CN)
(74) Representative: Gill Jennings & Every LLP
(86) International application number: PCT/EP2018/071243
(87) International publication number: WO 2020/030239

(56) References cited:
- WO-A1-2008/029083
- WO-A2-2009/036124
- US-A1- 2011 057 629

## Description

### TECHNICAL FIELD

The disclosure relates to a printed wiring board for use in an electronic device.

### BACKGROUND

Electronic devices may be provided with magnet actuators in order to generate, e.g., sound waves.

As disclosed in GB2532436, the magnet actuator may comprise magnets which either attract or repulse each other. Initially, the magnets are arranged in force equilibrium, but in order to generate sound waves the attractive or repulsive force between the magnets is changed by means of an electric current passing through a coil located between the magnets, the current causing at least one of the magnets to move such that the distance between the magnets decreases or increases.

The coil of GB2532436 may be glued to the top of one of the magnets, or wound around the side of a magnet, and may be electrically coupled to an audio signal input by means of a wire. When used for electronic devices, the components of the magnet actuator have to be so small that it is difficult to manufacture as well as assemble the components, in particular the coil. Furthermore, the coil generates undesired heat which is mainly conducted directly to the magnet, which could become demagnetised should the temperature become too high.

### SUMMARY

It is an object to provide an improved printed wiring board. The foregoing and other objects are achieved by the features of the independent claims. Further implementation forms are apparent from the dependent claims, the description, and the figures.

The invention has been defined in the independent claims. Further specific technical features have been defined in the dependent claims.

According to a first aspect, there is provided a printed wiring board (also called printed circuit board) for use in an electronic device, the printed wiring board comprising integrated circuits and a voice coil, the voice coil being formed integrally with the printed wiring board.

Such a solution allows the printed wiring board and voice coil to be configured as one integral component, as opposed to two separate discrete components, which integral component is easily mounted in an electronic device. Furthermore, by integrating the voice coil with the printed wiring board, the heat generated by the coil will have less impact on adjacent components such as magnets since the material of the printed wired board distributes heat approximately 10 times better than air. Additionally, there is no need for additional support means for assembling the voice coil.

In a possible implementation form of the first aspect, at least one of the integrated circuits is an audio amplifier connected to the voice coil, facilitating a component which is easily mounted in an electronic device and which is reliable since there is no need to accommodate possible movement between the voice coil and the audio amplifier.

In a further possible implementation form of the first aspect, at least one of the integrated circuits is a main processor for the electronic device, facilitating a component which is easily mounted in an electronic device.

In a further possible implementation form of the first aspect, the printed wiring board further comprises a fixed magnet attached to the printed wiring board such that the fixed magnet is superimposed over the voice coil layers, allowing a plurality of actuating components to be interconnected which facilitates simple and efficient mounting of the actuating components within, e.g., an electronic device.

In a further possible implementation form of the first aspect, the printed wiring board comprises at least one printed wiring board layer, and the voice coil is arranged in at least a first voice coil layer and a second voice coil layer, a voice coil interconnecting section extending between the first voice coil layer and the second voice coil layer, allowing an increased amount of voice coil to be used.

In a further possible implementation form of the first aspect, coil windings of a voice coil layer are arranged in a spiral-shaped pattern, the coil windings of a first voice coil layer or a second voice coil layer extending in a direction from an outer periphery of the spiral-shaped pattern towards a center of the spiral-shaped pattern, and the coil windings of a second voice coil layer or a first voice coil layer extending in a direction from a center of the spiral-shaped pattern towards an outer periphery of the spiral-shaped pattern, and wherein the voice coil interconnecting section extends between the first voice coil layer and the second voice coil layer adjacent a center of the spiral-shaped pattern or adjacent an outer periphery of the spiral-shaped pattern, allowing a spatially efficient distribution of voice coil layers.

In a further possible implementation form of the first aspect, the printed wiring board comprises at least two printed wiring board layers, each printed wiring board layer comprising a first voice coil layer or a second voice coil layer, wherein each first voice coil layer or second voice coil layer is connected to at least one second voice coil layer or first voice coil layer by means of a voice coil interconnecting section adjacent the center of the spiral-shaped pattern, and wherein each second voice coil layer or first voice coil layer is connected to at least one first voice coil layer or second voice coil layer by means of a voice coil interconnecting section adjacent the outer periphery of the spiral-shaped pattern, allowing a stable yet spatially efficient increase in the number of voice coil layers.

In a further possible implementation form of the first aspect, the printed wiring board layers alternate such that every other printed wiring board layer comprises a first voice coil layer and every other printed wiring board layer comprises a second voice coil layer, facilitating an as simple, layered voice coil structure as possible.

In a further possible implementation form of the first aspect, the printed wiring board layer comprises a throughput for receiving the voice coil interconnecting section extending between the first voice coil layer section and the second voice coil layer, facilitating a discrete yet secure transition between voice coil layers.

According to a second aspect, there is provided an electronic device comprising a movable surface and a device chassis, interconnected by means of a resilient element, a printed wiring board according to the above arranged between the movable surface and the device chassis, the printed wiring board being attached to the device chassis, the printed wiring board being the main printed wiring board of the electronic device, and a moveable magnet attached to the movable surface, the printed wiring board and the moveable magnet being adapted for moving the movable surface relative to the device chassis. Such a solution facilitates an electronic device which comprises fewer discrete parts and which is cheap and reliable.

In a possible implementation form of the second aspect, movement of the movable surface generates vibrations within the electronic device, which may be used as haptic means or for generating sound waves.

In a further possible implementation form of the second aspect, a fixed magnet of the printed wiring board and the moveable magnet are arranged so that a magnetic field, generated by the fixed magnet and the moveable magnet, causes an attractive force between the fixed magnet and the moveable magnet, maintaining the fixed magnet and the moveable magnet in a force equilibrium state, and wherein manipulating electrical current in a voice coil of the printed wiring board causes a change in the attractive force thereby causing a displacement between the fixed magnet and the moveable magnet, allowing a simple yet reliable construction.

In a further possible implementation form of the second aspect, the printed wiring board is arranged such that the fixed magnet and the moveable magnet are located on opposite sides of the printed wiring board, and an air gap is provided between the moveable magnet and the printed wiring board, facilitating a compact actuating arrangement.

In a further possible implementation form of the second aspect, a first air gap is provided between the moveable magnet and the printed wiring board when the attractive force is of a first magnitude, and a second air gap, smaller than the first air gap, is provided between the moveable magnet and the printed wiring board when the attractive force is of a second magnitude, allowing generation of vibrations.

In a further possible implementation form of the second aspect, the electronic device further comprises a first housing and a second housing, the fixed magnet being at least partially located within the first housing, and the moveable magnet being at least partially located within the second housing, the first housing and the second housing limiting the magnetic field to a space within at least one of the first housing and the second housing, preventing the magnetic field from interfering with other components.

This and other aspects will be apparent from and the implementation(s) described below.

### BRIEF DESCRIPTION OF THE DRAWINGS

In the following detailed portion of the present disclosure, the aspects, implementations, and implementations will be explained in more detail with reference to the example implementations shown in the drawings, in which:
Fig. 1 shows a schematic, cross-sectional side view of a printed wiring board and an electronic device in accordance with one implementation of the present disclosure;
Fig. 2 shows a partial, cross-sectional side view of a printed wiring board and an electronic device in accordance with one implementation of the present disclosure;
Fig. 3 shows a partial, cross-sectional perspective view of the printed wiring board and the electronic device shown in Fig. 1.
Fig. 4 shows a partial, cross-sectional perspective view of the printed wiring board and electronic device shown in Fig. 2;
Fig. 5 shows a partial, schematic side view of a printed wiring board in accordance with one implementation of the present disclosure.

### DETAILED DESCRIPTION

To make the objectives, technical solutions, and advantages of this invention clearer, the following further describes various implementations in detail with reference to the accompanying drawings. The implementations described below are not all claimed, they are included to help understanding the context of the invention. While the description refers to various implementations, the embodiments of the invention are those which comprise at least all the features of an independent claim. Any implementation which does not fall within the scope of the claims does not form part of the invention, but rather included as an illustrative example that is useful for understanding the invention.

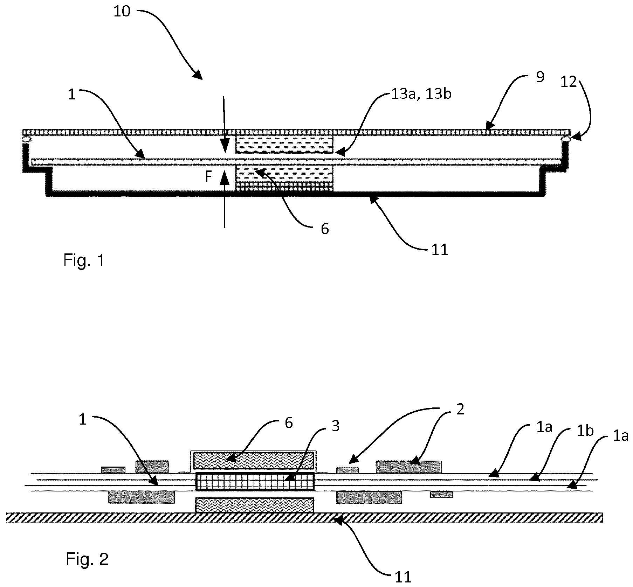

Figs. 2, 3, and 4 show a printed wiring board 1 in accordance with implementations of the present disclosure. The printed wiring board (PWB) 1 is preferably used in an electronic device 10 such as a smart phone or a tablet, however, it may be used in any suitable type of electronic device. The printed wiring board 1 could also be called printed circuit board (PCB) 1.

As shown in Fig. 2, the printed wiring board comprises at least one printed wiring board layer 1a, 1b, functioning as a carrier for other components as well as insulation.

The printed wiring board comprises at least one integrated circuit 2 and a voice coil 3. One of the integrated circuits 2 may be an audio amplifier connected to the voice coil 3, and one integrated circuit 2 may be the main processor for the electronic device. Hence, the printed wiring board may be a main PWB or PCB of the electronic device.

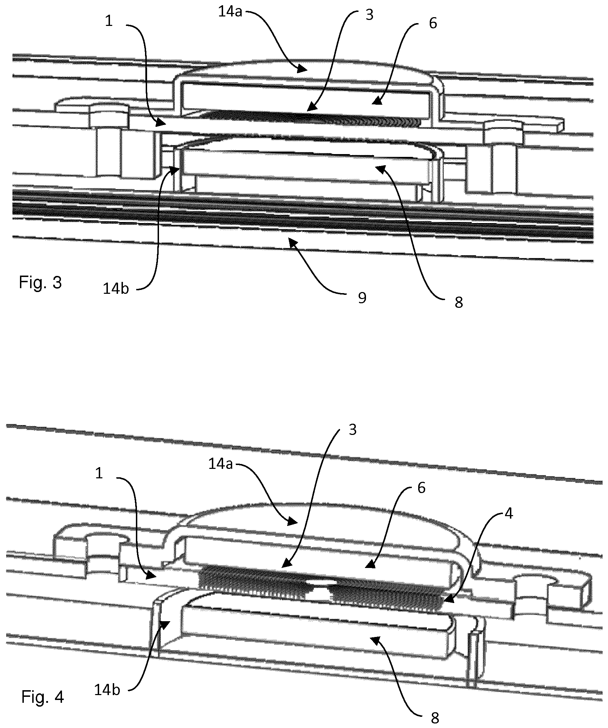

The voice coil 3 is preferably made of copper and formed integrally with the printed wiring board layer(s) 1a, 1b, as shown more clearly in Figs. 3 and 4. By integrally is meant that the voice coil is part of the printed wiring board as a result of the voice coil being printed onto a printed wiring board layer 1a, 1b. The voice coil 3 is not a separate, discrete component such as a voice coil film stacked on top of a printed wired board layer 1a, 1b, but a fixed part of the printed wiring board 1.

The voice coil 3 is preferably arranged in at least a first voice coil layer 3a and a second voice coil layer 3b. The first voice coil layer 3a and the second voice coil layer 3b are arranged such that they are superimposed over each other and extend in a plane which is parallel with a main plane of the printed wiring board. The main plane of the printed wiring board 1 extends in parallel with the main plane of an electronic device 10 which the printed wiring board 1 is mounted into, and may, e.g., extend in parallel with a display of such an electronic device 10.

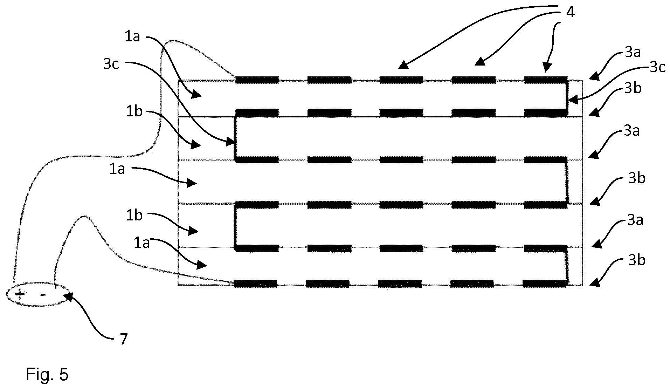

A voice coil interconnecting section 3c extends between the first voice coil layer 3a and the second voice coil layer 3b in a direction perpendicular to the first voice coil layer 3a and the second voice coil layer 3b. See Fig. 5 for a schematic illustration of how the printed wired board layers 1a, 1b and the voice coil layers 3a, 3b are arranged.

Each voice coil layer 3a, 3b comprises a plurality of coil windings 4 are arranged in a spiral-shaped pattern, the voice coil 3 extending in a direction from an outer periphery of the spiral-shaped pattern towards a center of the spiral-shaped pattern, or extending in an opposite direction, from a center of the spiral-shaped pattern towards an outer periphery of the spiral-shaped pattern. Figs. 4 and 5 indicate such a spiral-shaped pattern. The pattern is preferably essentially circular, but may also be rectangular, elliptical or any other suitable shape. The coil windings 4 extend in a plane perpendicular to the direction of the attractive force F caused by the magnetic field.

The coil windings 4 of one voice coil layer, i.e. the first voice coil layer 3a or the second voice coil layer 3b, extend in a direction from an outer periphery of the spiral-shaped pattern towards a center of the spiral-shaped pattern. Similarly, the coil windings 4 of another voice coil layer, i.e. the second voice coil layer 3b or the first voice coil layer 3a, extend in a direction from a center of the spiral-shaped pattern towards an outer periphery of the spiral-shaped pattern. In other words, the coil windings 4 of the first voice coil layer 3a and the coil windings 4 of the second voice coil layer 3b extend in opposite directions. The voice coil interconnecting section 3c extends between the first voice coil layer 3a and the second voice coil layer 3b adjacent either the center of the spiral-shaped pattern or adjacent the outer periphery of the spiral-shaped pattern, as shown in Fig. 5.

In one implementation, the printed wiring board 1 comprises at least two printed wiring board layers 1a, 1b, each printed wiring board layer 1a, 1b comprising a first voice coil layer 3a or a second voice coil layer 3b. Each first voice coil layer 3a, or second voice coil layer 3b, is connected to at least one second voice coil layer 3b, or first voice coil layer 3a by means of a voice coil interconnecting section 3c adjacent the center of the spiral-shaped pattern. Correspondingly, each second voice coil layer 3b, or first voice coil layer 3a, is connected to at least one first voice coil layer 3a, or second voice coil layer 3b, by means of a voice coil interconnecting section 3c adjacent the outer periphery of the spiral-shaped pattern.

The printed wiring board layers 1a, 1b alternate such that every other printed wiring board layer 1a comprises a first voice coil layer 3a and every other printed wiring board layer 1b comprises a second voice coil layer 3b.

The direction of the electric current in the voice coil 3 is preferably the same, either clockwise or anti-clockwise, in both first voice coil layer(s) 3a and second voice coil layer(s) 3b in order to generate a common magnetic displacement force.

The printed wiring board layers 1a, 1b preferably comprise a throughput 5 for receiving the voice coil interconnecting section 3c extending between the first voice coil layer section 3a and the second voice coil layer 3b.

The printed wiring board 1 further comprises a fixed magnet 6 attached to the printed wiring board 1 such that the fixed magnet 6 is superimposed over the voice coil layers 3a, 3b.

The printed wiring board 1 further comprises an electric source 7, the voice coil 3 being electrically connected to the electric source 7 as shown schematically in Fig. 5, the electrical source transferring electrical current to the voice coil 3.

The electronic device 10, shown schematically in Fig. 1, comprises a movable surface 9, such as a display, and a device chassis 11, interconnected by means of a resilient element 12 such as an elastic adhesive. The movable surface/display 9 may be made of glass and/or be elastic.

The printed wiring board 1 is arranged between the movable surface 9 and the device chassis 11, and is also attached to the device chassis 11. A moveable magnet 8 is attached to the movable surface 9. The printed wiring board 1 and the moveable magnet 8 are adapted for moving the movable surface 9 relative to the printed wiring board 1, and hence the device chassis 11, in response to manipulation of electrical current in the voice coil 3 of the printed wiring board 1.

The fixed magnet 6 of the printed wiring board 1 and the moveable magnet 8 are arranged so that a magnetic field, generated by the fixed magnet 6 and the moveable magnet 8, causes an attractive force F between the fixed magnet 6 and the moveable magnet 8, maintaining the fixed magnet 6 and the moveable magnet 8 in a force equilibrium state. Manipulating electrical current in the voice coil 3 of the printed wiring board 1 causes a change in the attractive force F thereby causing a continuous displacement between the fixed magnet 6 and the moveable magnet 8.

Subsequently, this displacement causes the movable surface 9 of the electronic device to move in relation to the device chassis 11. The movement of the movable surface 9 generates vibrations within the electronic device 10, the vibrations being used for generating sound waves or as a haptic means providing tactile feedback to the user.

The printed wiring board 1 is arranged such that the fixed magnet 6 and the moveable magnet 8 are located on opposite sides of the printed wiring board 1, and an air gap 13 is provided between the moveable magnet 8 and the printed wiring board 1.

A first air gap 13a is provided between the moveable magnet 8 and the printed wiring board 1 when the attractive force F is of a first magnitude, and a second air gap 13b, smaller than the first air gap 13a, is provided between the moveable magnet 8 and the printed wiring board 1 when the attractive force F is of a second magnitude. Hence, the moveable magnet 8 oscillates between two end positions, the one end position being defined by the height of the first air gap 13a. The other end position is at a point where the height of the air gap 13b is smaller than the height of the first air gap 13a.

The electronic device 10 may further comprise a first housing 14a and a second housing 14b, the fixed magnet 6 being at least partially located within the first housing 14a, and the moveable magnet 8 being at least partially located within the second housing 14b. The first housing 14a and the second housing 14b limit the magnetic field to a space within at least one of the first housing 14a and the second housing 14b. This prevents the magnetic field from interfering with other objects such as the other components of the electronic device. The first housing 14a and the second housing 14b are at least partly made of a magnetic material.

The first housing 14a and the second housing 14b may both be configured such that they have an open end and a closed base connected by at least one surrounding wall, e.g. being shaped as a cylinder having one sealed off end and one open end. The open end of the first housing 14a is connected to, or arranged directly in abutment with, the printed wiring board 1. The open end of the second housing 14b is directed towards the printed wiring board 1 and the first housing 14a.

The first housing 14a is essentially shaped to accommodate the fixed magnet 6. The second housing 14b is essentially shaped to accommodate the moveable magnet 8.

The reference signs used in the claims shall not be construed as limiting the scope.

The scope of protection shall be defined by the appended claims.

## Claims

1. An electronic device (10) comprising
a movable surface (9) and a device chassis (11), interconnected by means of a resilient element (12),
a printed wiring board (1) arranged between said movable surface (9) and said device chassis (11), said printed wiring board (1) being attached to said device chassis (11), said printed wiring board (1) being the main printed wiring board of said electronic device (10), wherein the printed wiring board (1) comprises integrated circuits (2) and a voice coil (3), said voice coil (3) being formed integrally with said printed wiring board (1), wherein at least one of said integrated circuits (2) is a main processor for the electronic device (10); wherein said printed wiring board further comprises a fixed magnet (6) attached to said printed wiring board (1) such that said fixed magnet (6) is superimposed over said voice coil (3); and
a moveable magnet (8) attached to said movable surface (9), wherein said printed wiring board (1) and said moveable magnet (8) being adapted for moving said movable surface (9) relative to said device chassis (11);
wherein
said fixed magnet (6) of said printed wiring board (1) and said moveable magnet (8) are arranged such that a magnetic field, generated by said fixed magnet (6) and said moveable magnet (8), causes an attractive force (F) between said fixed magnet (6) and said moveable magnet (8), maintaining said fixed magnet (6) and said moveable magnet (8) in a force equilibrium state, and
wherein manipulating electrical current in the voice coil (3) of said printed wiring board (1) causes a change in said attractive force (F) thereby causing a displacement between said fixed magnet (6) and said moveable magnet (8).
wherein the electronic device (10) further comprises a first housing (14a) and a second housing (14b), said fixed magnet (6) being at least partially located within said first housing (14a), and said moveable magnet (8) being at least partially located within said second housing (14b), wherein said first housing (14a) and said second housing (14b) limiting said magnetic field to a space within at least one of said first housing (14a) and said second housing (14b).

2. The electronic device (10) according to claim 1, wherein movement of said movable surface (9) generates vibrations within said electronic device (10).

3. The electronic device (10) according to claim 1 or 2, wherein said printed wiring board (1) is arranged such that said fixed magnet (6) and said moveable magnet (8) are located on opposite sides of said printed wiring board (1), and an air gap (13) is provided between said moveable magnet (8) and said printed wiring board (1).

4. The electronic device (10) according to claim 3, wherein a first air gap (13a) is provided between said moveable magnet (8) and said printed wiring board (1) when said attractive force (F) is of a first magnitude, and a second air gap (13b), smaller than said first air gap (13a), is provided between said moveable magnet (8) and said printed wiring board (1) when said attractive force (F) is of a second magnitude.

5. The electronic device (10) according to any one claims 1 to 4, wherein at least one of said integrated circuits (2) included in said printed wiring board (1) is an audio amplifier connected to said voice coil (3). [2]

6. The electronic device (10) according to any one of claims 1 to 5, wherein said printed wiring board comprises:
at least one printed wiring board layer (1a, 1b);
said voice coil (3) is arranged in at least a first voice coil layer (3a) and a second voice coil layer (3b); and a voice coil interconnecting section (3c) extending between said first voice coil layer (3a) and said second voice coil layer (3b).

7. The electronic device (10) according to claim 6, wherein coil windings (4) of a voice coil layer (3a, 3b) are arranged in a spiral-shaped pattern, the coil windings (4) of a first voice coil layer (3a) or a second voice coil layer (3b) extending in a direction from an outer periphery of said spiral-shaped pattern towards a center of said spiral-shaped pattern, and the coil windings (4) of a second voice coil layer (3b) or a first voice coil layer (3a) extending in a direction from a center of said spiral-shaped pattern towards an outer periphery of said spiral-shaped pattern, and wherein said voice coil interconnecting section (3c) extends between said first voice coil layer (3a) and said second voice coil layer (3b) adjacent a center of said spiral-shaped pattern or adjacent an outer periphery of said spiral-shaped pattern.

8. The electronic device (10) according to claim 7, wherein said printed wiring board comprises at least two printed wiring board layers (1a, 1b), each printed wiring board layer (1a, 1b) comprising a first voice coil layer (3a) or a second voice coil layer (3b),
wherein each first voice coil layer (3a) or second voice coil layer (3b) is connected to at least one second voice coil layer (3b) or first voice coil layer (3a) by means of a voice coil interconnecting section (3c) adjacent the center of said spiral-shaped pattern, and
wherein each second voice coil layer (3b) or first voice coil layer (3a) is connected to at least one first voice coil layer (3a) or second voice coil layer (3b) by means of a voice coil interconnecting section (3c) adjacent the outer periphery of said spiral-shaped pattern.

9. The electronic device (10) according to claim 8, wherein said printed wiring board layers (1a, 1b) alternate such that every printed wiring board layer (1a) comprises a first voice coil layer (3a) and every printed wiring board layer (1b) comprises a second voice coil layer (3b).

10. The electronic device (10) according to any one of claims 6 to 9, wherein said printed wiring board layer (1a, 1b) comprises a throughput (5) for receiving said voice coil interconnecting section (3c) extending between said first voice coil layer (3a) and said second voice coil layer (3b).

## Patentansprüche

1. Elektronische Vorrichtung (10), umfassend:
eine bewegliche Oberfläche (9) und einen Vorrichtungsrahmen (11), die mittels eines federnden Elements (12) miteinander verbunden sind,
eine Leiterplatte (1), die zwischen der beweglichen Oberfläche (9) und dem Vorrichtungsrahmen (11) angeordnet ist, wobei die Leiterplatte (1) an dem Vorrichtungsrahmen (11) befestigt ist, wobei die Leiterplatte (1) die Hauptleiterplatte der elektronischen Vorrichtung (10) ist, wobei die Leiterplatte (1) integrierte Schaltungen (2) und eine Schwingspule (3) umfasst, wobei die Schwingspule (3) einstückig mit der Leiterplatte (1) ausgebildet ist, wobei mindestens eine der integrierten Schaltungen (2) ein Hauptprozessor für die elektronische Vorrichtung (10) ist; wobei die Leiterplatte ferner einen feststehenden Magneten (6) umfasst, der an der Leiterplatte (1) derart befestigt ist, dass der feststehende Magnet (6) über die Schwingspule (3) gelegt ist; und
einen beweglichen Magneten (8), der an der beweglichen Oberfläche (9) befestigt ist, wobei die Leiterplatte (1) und der bewegliche Magnet (8) dazu angepasst sind, die bewegliche Oberfläche (9) relativ zu dem Vorrichtungsrahmen (11) zu bewegen;
wobei
der feststehende Magnet (6) der Leiterplatte (1) und der bewegliche Magnet (8) derart angeordnet sind, dass ein Magnetfeld, das durch den feststehenden Magneten (6) und den beweglichen Magneten (8) erzeugt wird, eine Anziehungskraft (F) zwischen dem feststehenden Magneten (6) und dem beweglichen Magneten (8) bewirkt, wobei der feststehende Magnet (6) und der bewegliche Magnet (8) in einem Kräftegleichgewichtszustand gehalten werden, und
wobei Verändern des elektrischen Stromes in der Schwingspule (3) der Leiterplatte (1) eine Änderung der Anziehungskraft (F) bewirkt, wodurch eine Verschiebung zwischen dem feststehenden Magneten (6) und dem beweglichen Magneten (8) bewirkt wird,
wobei die elektronische Vorrichtung (10) ferner ein erstes Gehäuse (14a) und ein zweites Gehäuse (14b) umfasst, wobei der feststehende Magnet (6) zumindest teilweise innerhalb des ersten Gehäuses (14a) befindlich ist und der bewegliche Magnet (8) zumindest teilweise innerhalb des zweiten Gehäuses (14b) befindlich ist, wobei das erste Gehäuse (14a) und das zweite Gehäuse (14b) das Magnetfeld auf einen Raum innerhalb zumindest eines des ersten Gehäuses (14a) und des zweiten Gehäuses (14b) begrenzen.

2. Elektronische Vorrichtung (10) nach Anspruch 1, wobei eine Bewegung der beweglichen Oberfläche (9) Schwingungen innerhalb der elektronischen Vorrichtung (10) erzeugt.

3. Elektronische Vorrichtung (10) nach Anspruch 1 oder 2, wobei die Leiterplatte (1) derart angeordnet ist, dass der feststehende Magnet (6) und der bewegliche Magnet (8) auf gegenüberliegenden Seiten der Leiterplatte (1) befindlich sind, und ein Luftspalt (13) zwischen dem beweglichen Magneten (8) und der Leiterplatte (1) bereitgestellt ist.

4. Elektronische Vorrichtung (10) nach Anspruch 3, wobei ein erster Luftspalt (13a) zwischen dem beweglichen Magneten (8) und der Leiterplatte (1) bereitgestellt ist, wenn die Anziehungskraft (F) eine erste Größe aufweist, und ein zweiter Luftspalt (13b), kleiner als der erste Luftspalt (13a), zwischen dem beweglichen Magneten (8) und der Leiterplatte (1) bereitgestellt ist, wenn die Anziehungskraft (F) eine zweite Größe aufweist.

5. Elektronische Vorrichtung (10) nach einem der Ansprüche 1 bis 4, wobei mindestens eine der integrierten Schaltungen (2), die in der Leiterplatte (1) beinhaltet sind, ein Audioverstärker ist, der mit der Schwingspule (3) verbunden ist. [2]

6. Elektronische Vorrichtung (10) nach einem der Ansprüche 1 bis 5, wobei die Leiterplatte Folgendes umfasst:
mindestens eine Leiterplattenschicht (1a, 1b);
wobei die Schwingspule (3) in mindestens einer ersten Schwingspulenschicht (3a) und einer zweiten Schwingspulenschicht (3b) angeordnet ist; und einen Schwingspulenverbindungsabschnitt (3c), der sich zwischen der ersten Schwingspulenschicht (3a) und der zweiten Schwingspulenschicht (3b) erstreckt.

7. Elektronische Vorrichtung (10) nach Anspruch 6, wobei Spulenwicklungen (4) einer Schwingspulenschicht (3a, 3b) in einem spiralförmigen Muster angeordnet sind, die Spulenwicklungen (4) einer ersten Schwingspulenschicht (3a) oder einer zweiten Schwingspulenschicht (3b) sich in einer Richtung von einem Außenumfang des spiralförmigen Musters zu einem Zentrum des spiralförmigen Musters erstrecken und die Spulenwicklungen (4) einer zweiten Schwingspulenschicht (3b) oder einer ersten Schwingspulenschicht (3a) sich in einer Richtung von einem Zentrum des spiralförmigen Musters zu einem Außenumfang des spiralförmigen Musters erstrecken und wobei sich der Schwingspulenverbindungsabschnitt (3c) zwischen der ersten Schwingspulenschicht (3a) und der zweiten Schwingspulenschicht (3b) benachbart zu einem Zentrum des spiralförmigen Musters oder benachbart zu einem Außenumfang des spiralförmigen Musters erstreckt.

8. Elektronische Vorrichtung (10) nach Anspruch 7, wobei die Leiterplatte mindestens zwei Leiterplattenschichten (1a, 1b) umfasst, wobei jede Leiterplattenschicht (1a, 1b) eine erste Schwingspulenschicht (3a) oder eine zweite Schwingspulenschicht (3b) umfasst,
wobei jede erste Schwingspulenschicht (3a) oder zweite Schwingspulenschicht (3b) mit mindestens einer zweiten Schwingspulenschicht (3b) oder ersten Schwingspulenschicht (3a) mittels eines Schwingspulenverbindungsabschnitts (3c) benachbart zu dem Zentrum des spiralförmigen Musters verbunden ist, und
wobei jede zweite Schwingspulenschicht (3b) oder erste Schwingspulenschicht (3a) mit mindestens einer ersten Schwingspulenschicht (3a) oder zweiten Schwingspulenschicht (3b) mittels eines Schwingspulenverbindungsabschnitts (3c) benachbart zu dem Außenumfang des spiralförmigen Musters verbunden ist.

9. Elektronische Vorrichtung (10) nach Anspruch 8, wobei die Leiterplattenschichten (1a, 1b) sich derart abwechseln, dass jede Leiterplattenschicht (1a) eine erste Schwingspulenschicht (3a) umfasst und jede Leiterplattenschicht (1b) eine zweite Schwingspulenschicht (3b) umfasst.

10. Elektronische Vorrichtung (10) nach einem der Ansprüche 6 bis 9, wobei die Leiterplattenschicht (1a, 1b) einen Durchsatz (5) zum Aufnehmen des Schwingspulenverbindungsabschnitts (3c), der sich zwischen der ersten Schwingspulenschicht (3a) und der zweiten Schwingspulenschicht (3b) erstreckt, umfasst.

## Revendications

1. Dispositif électronique (10) comprenant
une surface mobile (9) et un châssis de dispositif (11), reliés entre eux au moyen d'un élément élastique (12),
une carte de circuit imprimé (1) agencée entre ladite surface mobile (9) et ledit châssis de dispositif (11), ladite carte de circuit imprimé (1) étant fixée audit châssis de dispositif (11), ladite carte de circuit imprimé (1) étant la carte de circuit imprimé principale dudit dispositif électronique (10), dans lequel la carte de circuit imprimé (1) comprend des circuits intégrés (2) et une bobine acoustique (3), ladite bobine acoustique (3) étant formée d'un seul tenant avec ladite carte de circuit imprimé (1), dans lequel au moins l'un desdits circuits intégrés (2) est un processeur principal pour le dispositif électronique (10) ; dans lequel ladite carte de circuit imprimé comprend également un aimant fixe (6) fixé à ladite carte de circuit imprimé (1) de telle sorte que ledit aimant fixe (6) soit superposé sur ladite bobine acoustique (3) ; et
un aimant mobile (8) fixé à ladite surface mobile (9), dans lequel ladite carte de circuit imprimé (1) et ledit aimant mobile (8) étant adaptés pour déplacer ladite surface mobile (9) par rapport audit châssis de dispositif (11) ;
dans lequel
ledit aimant fixe (6) de ladite carte de circuit imprimé (1) et ledit aimant mobile (8) sont agencés de telle sorte qu'un champ magnétique, généré par ledit aimant fixe (6) et ledit aimant mobile (8), provoque une force d'attraction (F) entre ledit aimant fixe (6) et ledit aimant mobile (8), maintenant ledit aimant fixe (6) et ledit aimant mobile (8) dans un état d'équilibre de force, et
dans lequel la manipulation du courant électrique dans la bobine acoustique (3) de ladite carte de circuit imprimé (1) provoque un changement dans ladite force d'attraction (F), provoquant ainsi un déplacement entre ledit aimant fixe (6) et ledit aimant mobile (8).
dans lequel le dispositif électronique (10) comprend également un premier boîtier (14a) et un second boîtier (14b), ledit aimant fixe (6) étant au moins partiellement situé à l'intérieur dudit premier boîtier (14a), et ledit aimant mobile (8) étant au moins partiellement situé à l'intérieur dudit second boîtier (14b), dans lequel ledit premier boîtier (14a) et ledit second boîtier (14b) limitant ledit champ magnétique à un espace à l'intérieur d'au moins l'un dudit premier boîtier (14a) et dudit second boîtier (14b).

2. Dispositif électronique (10) selon la revendication 1, dans lequel le mouvement de ladite surface mobile (9) génère des vibrations à l'intérieur dudit dispositif électronique (10).

3. Dispositif électronique (10) selon la revendication 1 ou 2, dans lequel ladite carte de circuit imprimé (1) est agencée de telle sorte que ledit aimant fixe (6) et ledit aimant mobile (8) sont situés sur des côtés opposés de ladite carte de circuit imprimé (1), et un entrefer (13) est prévu entre ledit aimant mobile (8) et ladite carte de circuit imprimé (1).

4. Dispositif électronique (10) selon la revendication 3, dans lequel un premier entrefer (13a) est prévu entre ledit aimant mobile (8) et ladite carte de circuit imprimé (1) lorsque ladite force d'attraction (F) est d'une première intensité, et un second entrefer (13b), plus petit que ledit premier entrefer (13a), est prévu entre ledit aimant mobile (8) et ladite carte de circuit imprimé (1) lorsque ladite force d'attraction (F) est d'une seconde intensité.

5. Dispositif électronique (10) selon l'une quelconque des revendications 1 à 4, dans lequel au moins l'un desdits circuits intégrés (2) inclus dans ladite carte de circuit imprimé (1) est un amplificateur audio connecté à ladite bobine acoustique (3). [2]

6. Dispositif électronique (10) selon l'une quelconque des revendications 1 à 5, dans lequel ladite carte de circuit imprimé comprend :
au moins une couche de carte de circuit imprimé (1a, 1b) ;
ladite bobine acoustique (3) est agencée dans au moins une première couche de bobine acoustique (3a) et une seconde couche de bobine acoustique (3b) ; et une section d'interconnexion de bobine acoustique (3c) se prolongeant entre ladite première couche de bobine acoustique (3a) et ladite seconde couche de bobine acoustique (3b).

7. Dispositif électronique (10) selon la revendication 6, dans lequel des enroulements de bobine (4) d'une couche de bobine acoustique (3a, 3b) sont agencés selon un motif en forme de spirale, les enroulements de bobine (4) d'une première couche de bobine acoustique (3a) ou d'une seconde couche de bobine acoustique (3b) se prolongeant dans une direction allant d'une périphérie extérieure dudit motif en forme de spirale vers un centre dudit motif en forme de spirale, et les enroulements de bobine (4) d'une seconde couche de bobine acoustique (3b) ou d'une première couche de bobine acoustique (3a) se prolongeant dans une direction allant d'un centre dudit motif en forme de spirale vers une périphérie extérieure dudit motif en forme de spirale, et dans lequel ladite section d'interconnexion de bobine acoustique (3c) se prolonge entre ladite première couche de bobine acoustique (3a) et ladite seconde couche de bobine acoustique (3b) adjacente à un centre dudit motif en forme de spirale ou adjacente à une périphérie extérieure dudit motif en forme de spirale.

8. Dispositif électronique (10) selon la revendication 7, dans lequel ladite carte de circuit imprimé comprend au moins deux couches de carte de circuit imprimé (1a, 1b), chaque couche de carte de circuit imprimé (1a, 1b) comprenant une première couche de bobine acoustique (3a) ou une seconde couche de bobine acoustique (3b),
dans lequel chaque première couche de bobine acoustique (3a) ou seconde couche de bobine acoustique (3b) est connectée à au moins une seconde couche de bobine acoustique (3b) ou première couche de bobine acoustique (3a) au moyen d'une section d'interconnexion de bobine acoustique (3c) adjacente au centre dudit motif en forme de spirale, et
dans lequel chaque seconde couche de bobine acoustique (3b) ou première couche de bobine acoustique (3a) est connectée à au moins une première couche de bobine acoustique (3a) ou seconde couche de bobine acoustique (3b) au moyen d'une section d'interconnexion de bobine acoustique (3c) adjacente à la périphérie extérieure dudit motif en forme de spirale.

9. Dispositif électronique (10) selon la revendication 8, dans lequel lesdites couches de carte de circuit imprimé (1a, 1b) alternent de telle sorte que chaque couche de carte de circuit imprimé (1a) comprend une première couche de bobine acoustique (3a) et chaque couche de carte de circuit imprimé (1b) comprend une seconde couche de bobine acoustique (3b).

10. Dispositif électronique (10) selon l'une quelconque des revendications 6 à 9, dans lequel ladite couche de carte de circuit imprimé (1a, 1b) comprend un passage (5) pour recevoir ladite section d'interconnexion de bobine acoustique (3c) se prolongeant entre ladite première couche de bobine acoustique (3a) et ladite seconde couche de bobine acoustique (3b).
